Europäisches Patentamt

European Patent Office

Office européen des brevets

(19)

(11) Publication number: **0 126 417**
**A2**

# (12) EUROPEAN PATENT APPLICATION

(21) Application number: **84105523.9**

(22) Date of filing: **15.05.84**

(51) Int. Cl.³: **H 01 L 31/16**
**// G21K4/00**

(30) Priority: **16.05.83 JP 86225/83**

(43) Date of publication of application: **28.11.84**
**Bulletin 84/48**

(84) Designated Contracting States: **DE FR NL**

(71) Applicant: **FUJI PHOTO FILM CO., LTD., 210 Nakanuma Minami Ashigara-shi, Kanagawa 250-01 (JP)**

(72) Inventor: **Hosoi, Yuichi c/o Fuji Photo Film Co. Ltd., 798 Miyanodai Kaisei-machi, Ashigara-kami-gun Kanagawa (JP)**
Inventor: **Miyahara, Junji c/o Fuji Photo Film Co. Ltd., 798 Miyanodai Kaisei-machi, Ashigara-kami-gun Kanagawa (JP)**

(74) Representative: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22 (DE)**

(54) **Radiation image detector and method for detecting radiation image using said radiation image detector.**

(57) A radiation image detector which comprises: a photosensitive member comprising numerous photosensitive elements in regular and two-dimensional arrangement; and a phosphor layer provided on said photosensitive member.

A method for detecting radiation image using said detector which comprises steps of: causing a radiation having passed through an object to impinge upon the phosphor layer of the radiation image detector; and photoelectrically detecting the light emitted from said phosphor layer upon exposure to a radiation with the photosensitive member thereof.

(a)

(b)

EP 0 126 417 A2

# RADIATION IMAGE DETECTOR AND METHOD FOR DETECTING RADIATION IMAGE USING SAID RADIATION IMAGE DETECTOR

## BACKGROUND OF THE INVENTION

### FIELD OF THE INVENTION

The present invention relates to a radiation image detector and a method for detecting radiation image using said detector. More particularly, the present invention relates to a radiation image detector which employs the combination of a phosphor and photosensitive elements, and a method for detecting radiation image using said detector.

### DESCRIPTION OF THE PRIOR ART

In a variety of radiography such as that for diagnosis and that for nondistructive inspection, the so-called radiographic method using a combination of a radiographic intensifying screen and a radiographic film is generally utilized as a method for obtaining a radiation image of an object. In this method, when a radiation such as X-rays having passed through an object impinges upon a radiographic intensifying screen, a phosphor contained in the intensifying screen absorbs the radiation energy and emits light (spontaneous emission). A radiographic film provided in close contact with the radiographic intensifying screen is exposed to the light emitted by the screen to form a radiation image of the object on the film. Thus, the radiation image is directly obtained as a visible image on the radiographic film.

In order to obtain a radiation image having a desired density, contrast and size, it has been known that the image information is photoelectrically read out in such a manner that the visible image on the radiographic film is scanned with a light beam to convert the image into an electric signal, and then the electric signal is subjected to a suitable image processing to reproduce an image meeting the purpose.

As mentioned above, the conventional radiographic method has been utilized widely in the variety of radiography. It is accordingly desired that the sensitivity of the radiographic method and the quality of an image (sharpness and graininess, etc.) provided thereby are made as high as possible.

It is essential in the conventional radiographic method that the radiation image is directly visualized on a radiographic film, and accordingly the combination of the radiographic film and radiographic intensifying screen whose sensitivity regions are coincident with each other is necessarily used.

In addition, in order to process the radiation image for adjustment of its density and contrast, for enlargement or for reduction according to the purpose, it is required that the obtained radiation image is converted to an electric signal temporarily. Consequently, the read-out operation is necessarily performed by means of an image read-out apparatus, so that the procedure in the radiographic method is complicated.

## SUMMARY OF THE INVENTION

The present inventors have studied to solve the above-mentioned problems in the conventional radiographic method, and found that these problems are solved or reduced by directly obtaining image information on a radiation image of an object as an electric signal by means of a radiation image detector, which comprises a photosensitive member composed of numerous photosensitive elements in regular and two-dimensional arrangement and a phosphor layer provided thereon.

The present invention provides a radiation image detector which comprises:

1) a photosensitive member comprising numerous photosensitive elements in regular and two-dimensional arrangement; and

2) a phosphor layer provided on said photosensitive member.

Further, the present invention provides a method for detecting radiation image which comprises steps of:

causing a radiation having passed through an object to impinge onto a phosphor layer of a radiation image detector, which comprises a photosensitive member comprising numerous photosensitive elements in regular and two-dimensional arrangement and the phosphor layer provided thereon; and

photoelectrically detecting the light emitted from said phosphor layer upon exposure to a radiation with said photosensitive member.

## BRIEF DESCRIPTION OF DRAWINGS

Figures 1-(a) and 1-(b) are a schematic partial section view and partial illustrative diagram which show the embodiment of the radiation image detector of the present invention, respectively.

Figure 2 is a schematic circuit diagram which shows the embodiment of the radiation image detector of the present invention.

## DETAILED DESCRIPTION OF THE INVENTION

In the present invention, the radiation image (i.e., transmitted radiation image) of an object can be directly obtained as an electric signal using the radiation image detector which comprises a phosphor layer and a photosensitive member comprising numerous photosensitive elements, by causing the phosphor of the phosphor layer to absorb a radiation such as X-rays which has impinged upon the phosphor layer after passing through the object and to emit light immediately, and then causing the light detecting menber to receive the emitted light and to convert it into an electric signal.

According to the present invention, it is possible to reproduce an image from the obtained electric signal having the radiation image information with a desired means such as display on CRT, etc. or record on a heatsensitive recording material, as well as to visualize an image on a photosensitive film in the conventional manner. In addition, the radiation image information can be also recorded and stored in another form by using a magnetic tape or the like.

Further, even if the level of the obtained electric signal varies with fluctuation of the intensity of radiation employed to irradiate an object, variation of the irradiation condition and condition of the object, and fluctuation of the sensitivity of the phosphor, the image information which is hardly affected by these factors can be obtained by amplifying the electric signal suitably. That is, according to the present invention, the radiation dose applied to the object can be reduced by adjusting the output of the electric signal, as compared with the conventional method, so that this method is especially useful in the case of the object being a human body.

In addition, the obtained electric signal may be subjected to the suitable image processing in the present invention, if desired, to give a visualized image with an excellent readability.

In the present invention, the photosensitive material necessarily employed to give an image in the conventional radiographic method, such as a radiographic film, is not required, and the requirement that the sensitivity region of the photosensitive material overlaps with that of the radiographic intensifying screen used therewith is eliminated.

The radiation image detector according to the present invention basically comprises a photosensitive member comprising numerous photosensitive elements in regular and two-dimensional arrangement, and a phosphor layer provided thereon.

In the photosensitive member, numerous photosensitive elements are arranged regularly and horizontally to form a plane. A photosensitive element employed in the photosensitive member comprises a light receiving section to receive the light emitted by the phosphor layer and a transferring section to sequentially output an electric charge obtained through the photoelectrical conversion at the light receiving section as an electric signal. As the photosensitive element, a known solid-state imaging device using an amorphous semiconductor or the like can be employed.

Examples of such solid-state imaging device include sensors such as MOS (Metal Oxide Semiconductor), CCD (Charged Coupled Device), BBD (Bucket Brigade Device), and CID (Charged Isolated Device). Examples of photoconductive material employed for the solid-state imaging devices include amorphous silicon ($\alpha$-Si), ZnO, and CdS.

The photosensitive member is provided with an insulating layer, and a phosphor layer is provided on the insulating layer. Examples of the material of the insulating layer include light-transmissive insulating materials such as glass and transparent polymeric material.

The phosphor layer usually comprises a binder and phosphor particles dispersed therein.

A variety of phosphors employable for a radiographic intensifying screen in the conventional radiographic method can be employed in the present invention. Examples of the phosphor preferably employable in the invention include:

tungstate phosphors such as $CaWO_4$, $MgWO_4$, and $CaWO_4$: Pb;

terbium activated rare earth oxysulfide phosphors such as $Y_2O_2S$:Tb, $Gd_2O_2S$:Tb, $La_2O_2S$:Tb, $(Y,Gd)_2O_2S$:Tb, and $(Y,Gd)_2O_2S$:Tb,Tm;

terbium activated rare earth phosphate phosphors such as $YPO_4$:Tb, $GdPO_4$:Tb, and $LaPO_4$:Tb;

terbium activated rare earth oxyhalide phosphors such as LaOBr:Tb, LaOBr:Tb,Tm, LaOCℓ:Tb, LaOCℓ:Tb,Tm, GdOBr:Tb, and GdOCℓ:Tb;

thulium activated rare earth oxyhalide phosphors such as LaOBr:Tm and LaOCℓ:Tm;

barium sulfate phosphors such as $BaSO_4$:Pb, $BaSO_4$:$Eu^{2+}$, and $(Ba,Sr)SO_4$:$Eu^{2+}$;

divalent europium activated alkaline earth metal fluorohalide phosphors such as BaFCℓ:$Eu^{2+}$, BaFBr:$Eu^{2+}$, BaFCℓ:$Eu^{2+}$,Tb, BaFBr:$Eu^{2+}$,Tb, $BaF_2 \cdot BaCℓ_2 \cdot KCℓ$:$Eu^{2+}$, $BaF_2 \cdot BaCℓ_2 \cdot xBaSO_4 \cdot KCℓ$:$Eu^{2+}$, and $(Ba,Mg)F_2 \cdot BaCℓ_2 \cdot KCℓ$:$Eu^{2+}$;

iodide phosphors such as CsI:Na, CsI:Tℓ, NaI:Tℓ, and KI:Tℓ;

sulfide phosphors such as ZnS:Ag, (Zn,Cd)S:Ag, (Zn,Cd)S:Cu, and (Zn,Cd)S:Cu,Aℓ; and

hafnium phosphate phosphors such as $HfP_2O_7$:Cu.

The above-described phosphors are given by no means to restrict the phosphor employable in the present invention. Any other phosphors can also be employed, provided that the phosphor emits light having a wavelength within near ultraviolet to visible region when exposed to a radiation such as X-rays.

However, it is required for the phosphor employed in the present invention that the wavelength region of light emission thereof overlaps with the wavelength region of light absorption of the photoconductive material employed in the light receiving section of photosensitive element. More in detail, it is required in the present invention to select such a phosphor and photoconductive material that at least a part of the wavelength region of emission of the former coincides with at least a part of the wavelength region of absorption of the latter. For example, in the case of employing α-Si as the photoconductive material, a phosphor having an emission wavelength of near 600 nm is preferably employed in combination therewith. Otherwise, in the case of employing a divalent europium activated alkaline earth metal fluorohalide phosphor (with a peak wavelength of emission of approximately 390 nm), ZnS and CdS are preferably employed as the photoconductive material.

Examples of the binder to be contained in the phosphor layer include: natural polymers such as proteins (e.g. gelatin), polysaccharides (e.g. dextran) and gum arabic; and synthetic polymers such as polyvinyl butyral, polyvinyl acetate, nitrocellulose, ethylcellulose, vinylidene chloride-vinyl chloride copolymer, polymethyl methacrylate, vinyl chloride-vinyl acetate copolymer, polyurethane, cellulose acetate butyrate, polyvinyl alcohol, and linear polyester.

The phosphor layer can be formed on the insulating layer, for instance, by the following procedure.

In the first place, phosphor particles and a binder are added to an appropriate solvent such as lower alcohol, ketone, ester, or ether, and then they are mixed to prepare a coating dispersion of the phosphor particles in the binder solution.

The mixing ratio between the binder and the phosphor in the coating dispersion varies depending on the characteristics of the radiation image detector to be obtained, type of the photosensitive element employed, and nature of the phosphor employed, but in general the mixing ratio therebetween is within the range of from 1 : 1 to 1 : 100 (binder : phosphor, by weight), and in particular preferably from 1 : 8 to 1 : 40.

The coating dispersion may contain a variety of additives such as a dispersing agent for increasing the dispersibility of the phosphor particles therein and a plasticizer for increasing the bonding strength between the binder and phosphor particles in the phosphor layer after forming a layer.

The coating dispersion containing the phosphor particles and the binder prepared as described above is applied evenly onto the surface of the insulating layer to form a layer of the coating dispersion. The coating procedure can be carried out by a conventional method such as a method using a doctor blade, a roll coater, or knife coater.

After applying the coating dispersion to the insulating layer, the coating dispersion is then heated slowly to dryness so as to complete the formation of a phosphor layer. The thickness of the phosphor layer varies depending upon the characteristics of the aimed radiation image detector, nature of the phosphor, and the ratio between the binder and the phosphor, etc. Generally, the thickness of the phosphor layer is within a range of from 20 μm to 1 mm, and preferably from 50 to 500 μm.

The phosphor layer can be provided onto the insulating layer by the methods other than the method given in the above. For instance, the phosphor layer is initially prepared on a sheet such as a metal plate, glass plate, or a plastic sheet by coating the coating dispersion thereon and drying it, and thus prepared phosphor layer is then laminated on the insulating layer by pressing or using an adhesive agent.

The phosphor layer can be formed with no binder. For instance, the phosphor layer can be formed on the insulating layer by deposition of the phosphor particles thereon such as vacuum deposition.

A transparent protective film is preferably provided on the phosphor layer to protect the phosphor layer from physical shocks and chemical deterioration. The protective film can be made of a cellulose derivative such as cellulose acetate or nitrocellulose; or a synthetic polymer such as polymethyl methacrylate, polyvinyl butyral, polyvinyl formal, polycarbonate, polyvinyl acetate, vinyl chloride-vinyl acetate copolymer, polyethylene terephthalate, polyethylene, polyvinylidene chloride or polyamide. The protective film preferably has a thickness within the range of approximately 3 to 20 μm.

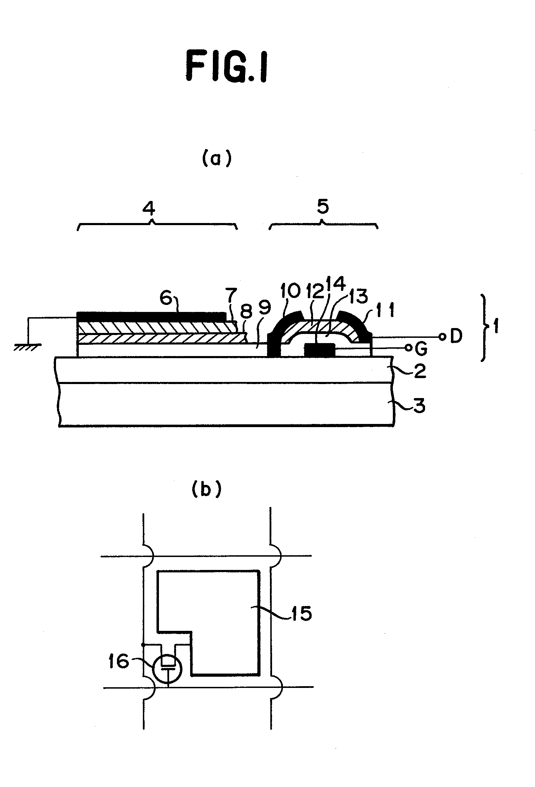

An embodiment of thus obtained radiation image detector is schematically shown in Figure 1.

Figure 1-(a) shows a vertical section view of one pixel of the radiation image detector comprising a photosensitive member and a phosphor layer provided thereon.

In Figure 1-(a), the radiation image detector is composed of a photosensitive element 1, an insulating layer 2 and a phosphor layer 3, superposed in this order. The photosensitive element 1 comprises a photodiode 4 and MOS:FET (Metal Oxide Semiconductor : Field Effect Transistor) 5, the former serving as a light receiving section and the latter as a transferring section. The photodiode 4 comprises a metal layer 6 of aluminum, etc., which serves as an earth, a p-type $\alpha$-Si:H layer 7, an i-type $\alpha$-Si:H layer 8, and a transparent electrode layer 9 of tin oxide ($SnO_2$), superposed in this order. The MOS:FET 5 comprises metal layers 10 and 11 of aluminum, etc., which are provided on both sides of an $\alpha$-Si:H layer 12, the $\alpha$-Si:H layer 12, an insulating layer 13 of silicon dioxide ($SiO_2$), and a transferring electrode 14 of aluminum, etc., provided in this order. The metal layer 11 serves as a drain and is connected to a transferring resistor. On the other hand, the transferring electrode 14 serves as a gate and is connected to a scanning pulse generator.

Figure 1-(b) shows a schematic illustrative diagram including wiring of a photosensitive element (i.e., a pixel) corresponding to Figure 1-(a). The photosensitive element comprises a light receiving section 15 and a transferring section 16, said transferring section being connected to the transferring resistor and scanning pulse generator.

In the above Figure 1, the area of the light receiving section is preferably as large as possible. The embodiment shown in Figure 1-(a) is given by no means to restrict the radiation image detector of the present invention.

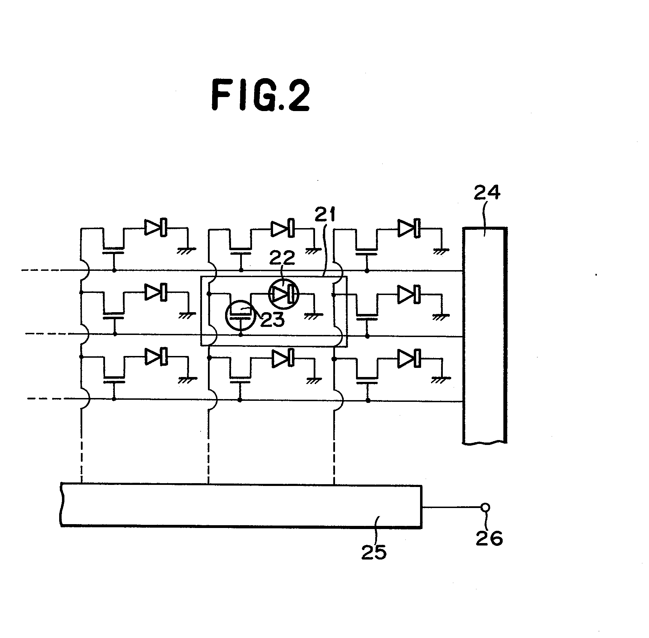

The method of the present invention for detection of a radiation image using the radiation image detector which comprises the photosensitive member and phosphor layer provided thereon, will be described referring to the partial vertical section view of the radiation image detector shown in the above-mentioned Figure 1-(a) and a whole circuit diagram of the radiation image detector shown in Figure 2.

Figure 2 is a schematic circuit diagram of the photosensitive member of the radiation image detector of the present invention. One pixel 21 corresponds to the element of Figures 1-(a) and 1-(b), and consists of a light receiving section 22 and a transferring section 23. Each transferring section in the photosensitive member is connected to a scanning pulse generator 24 and a transferring resistor 25, individually. On the transferring resistor 25, an output terminal 26 is provided.

In carrying out the detection method, an object is placed between a radiation generator and the radiation image detector, and a radiation having been generated by the generator and passed through the object impinges upon the phosphor layer-side surface of the radiation image detector: that is, the radiation having the intensity corresponding to the transmitted radiation image of the object impinges upon the lower side of Figure 1-(a). The phosphor particles in the phosphor layer 3 absorbs the radiation and immediately emit light. Then, the emitted light is received by the photodiode 4 in the photosensitive element 1 which constitutes a photosensitive member, and a signal charge corresponding to the light is produced in the photodiode 4. Thus, the signal charges are produced in every photosensitive element of the radiation image detector, the signal charge being proportional to the luminance of the emission, namely the intensity of the applied radiation.

When a transferring pulse generated by the scanning pulse generator 24 in the circuit diagram shown in Figure 2 reaches each photosensitive element in the top row, each of the transferring section on the top row turns to a switch-on state (in Figure 1-(a), such a state that a given voltage is applied to the transferring electrode 14 and an electric current passes from the metal layer 10 to the metal layer 11). Thus, the signal charge generated in the photodiode 4 in Figure 1-(a) is transferred via the MOS:FET 5. Consequently, a signal charge of each photosensitive element in the top row is simultaneously transferred to the transferring resistor 25, and an electric signal corresponding to each photosensitive element is output from the output terminal 26 of the transferring resistor 25.

Thus, the transferring pulse generated by the scanning pulse generator 24 is transferred to each row in the order of from the top to bottom row, and the electric signal produced in each photosensitive element of each row is sequentially output from the output terminal 26.

Subsequently, the output electric signal is amplified in an amplifier and reproduced as an image in an image reproducing apparatus. The obtained electric signal may be subjected to the image processing such as spatial frequency processing, gradiation processing, addition averaging processing, reduction processing and enlarging processing, if desired. Thus reproduced image can be recorded on a recording medium, or displayed on a displaying device. Examples of the recording medium include a medium for recording optically by scanning with laser beam on a photosensitive material, or a medium for recording on a heatsensitive recording material using thermic rays. Examples of the image displaying device include a variety of displaying devices based on various systems such as a means for visualizing electrically on CRT, etc., or a means for printing a radiation image displayed on CRT by means of video-printer. Furthermore, the radiation image information on the object may be recorded and stored on a magnetic tape.

In the radiation image detector of the present invention, for instance, a photosensitive element having a size (area) of approximately 200 μm x 200 μm for a pixel may be employed. For instance, the radiation image detector of the invention may consist of 2150 x 1750 pixels, if the size of the radiation image detector is assumed to be identical to a typical radiographic intensifying screen (430 mm x 354 mm). However, the size of the radiation image detector and photosensitive element employed in the invention are by no means restricted to the above-mentioned size. As a material of photosensitive element capable of forming such a large and uniform plane, α-Si is preferably employed. For the radiation image detector of the above-mentioned constitution and size, for example, the pulse generated by the scanning pulse generator preferrably has an output of approximately 3 kHz.

In the radiography using the radiation image detector of the present invention, the conventional procedure in which a radiographic intensifying screen and radiographic film having the sensitivity region coincident with each other are placed together in layers can be eliminated. Further, according to the method for detecting radiation image of the present invention, the adverse effect of said procedure on the image to be obtained can be also eliminated, because the detection of a radiation
is entirely conducted in a solid-state system.

CLAIMS:

1. A radiation image detector which comprises:

1) a photosensitive member comprising numerous photosensitive elements in regular and two-dimensional arrangement, and

2) a phosphor layer provided on said photosensitive member.

2. The radiation image detector as claimed in claim 1, in which the photosensitive element comprises a light receiving section and a transferring section, said light receiving section being composed of photodiode and said transferring section being composed of MOS transistor.

3. The radiation image detector as claimed in claim 1 or 2, in which the phosphor layer contains a terbium activated rare earth oxysulfide phosphor.

4. The radiation image detector as claimed in claim 1 or 2, in which the phosphor layer contains a divalent europium activated alkaline earth metal fluorohalide phosphor.

5. A method for detecting radiation image which comprises steps of:

causing a radiation having passed through an object to impinge upon a phosphor layer of a radiation image detector, which comprises a photosensitive member comprising numerous photosensitive elements in regular and two-dimensional arrangement and the phosphor layer provided thereon; and

photoelectrically detecting the light emitted from said phosphor layer upon exposure to a radiation with said photosensitive member.

6.    The method for detecting radiation image as claimed in claim 5, in which the photosensitive element comprises a light receiving section and a transferring section, said light receiving section being composed of photodiode and said transferring section being composed of MOS transistor.

7.    The method for detecting radiation image as claimed in claim 5 or 6, in which the phosphor layer contains a terbium activated rare earth oxysulfide phosphor.

8.    The method for detecting radiation image as claimed in claim 5 or 6, in which the phosphor layer contains a divalent europium activated alkaline earth metal fluorohalide phosphor.

# FIG.1

(a)

(b)

# FIG.2